# EUROPEAN PATENT APPLICATION

(11) **EP 2 453 566 A1**
(43) Date of publication of application: **16.05.2012**
(21) Application number: 11189265.9
(22) Date of filing: 15.11.2011
(51) Int. Cl.: H02M 3/158, H02M 3/335, H03K 17/30

(54) **DC-DC converter comprising FET switch and substrate biasing circuit**

(30) Priority: 15.11.2010 IT TO20100907; 15.11.2010 IT TO20100908
(71) Applicant: Istituto Superiore Mario Boella Sulle Tecnologie dell'Informazione e Delle Telecomunicazioni, Torino (IT)
(72) Inventor: Franco, Guiseppe, 10138 Torino (IT); Renga, Flavio, 10138 Torino (IT)
(74) Representative: Jorio, Paolo

(57) **Abstract**

A conditioning circuit for the transfer of electric charge, which comprises a converter module (40, 50, 60, 70) in turn comprising an energy-storage element (31a, 31b; 61; 71a, 71b) applied to which is an input voltage (Vi) and a respective field-effect-transistor switch (32a, 32b; 52a, 52b; 62; 72a, 72b) controlled by a respective driving signal (Vpa, Vpb) for selectively enabling transfer of charge from the energy-storage element (31a, 31b; 61; 71a, 71b) to an energy-storage circuit (13, 22a, 22b, 46).

According to the invention, said respective field-effect-transistor switch (52a, 52b; 62; 72a, 72b) comprises a corresponding field-effect transistor (52a, 52b) and a biasing circuit (55a, 55b; 65; 75a, 75b; 85a, 85b) for biasing a substrate (56a, 56b) of said transistor (32a, 32b; 52a, 52b; 62; 72a, 72b), said biasing circuit being connected between said substrate (56a, 56b) and a reference node represented by a source electrode of said transistor (52a, 52b) or another node at a potential suitable for enabling operation of said transistor (52a, 52b; 62; 72a, 72b) in the linear region or in the region of saturation, said biasing circuit (55a, 55b; 65; 75a, 75b; 85a, 85b) being configured for providing a limiting resistance in regard to the current that flows from said reference node in the transistor (52a, 52b; 62; 72a, 72b) when it operates in the inhibition region.

## Description

The present invention relates to conditioning circuits for transfer of electric charge, in particular for application to energy conversion, and more in particular for energy harvesting, that comprise a converter module, in turn comprising an energy-storage element applied to which is an input voltage and a respective field-effect-transistor switch controlled by a respective driving signal for selectively enabling transfer of charge from the energy-storage element to an energy-storage circuit.

Energy-harvesting techniques refer to the methods via which the energy is obtained, captured, and stored from external sources, such as, for example, solar energy, thermal energy, wind energy, saline gradients, and kinetic energy. Usually said techniques refer to devices of small dimensions, wireless and autonomous, such as those used in electronic devices that can be worn and wireless sensor networks.

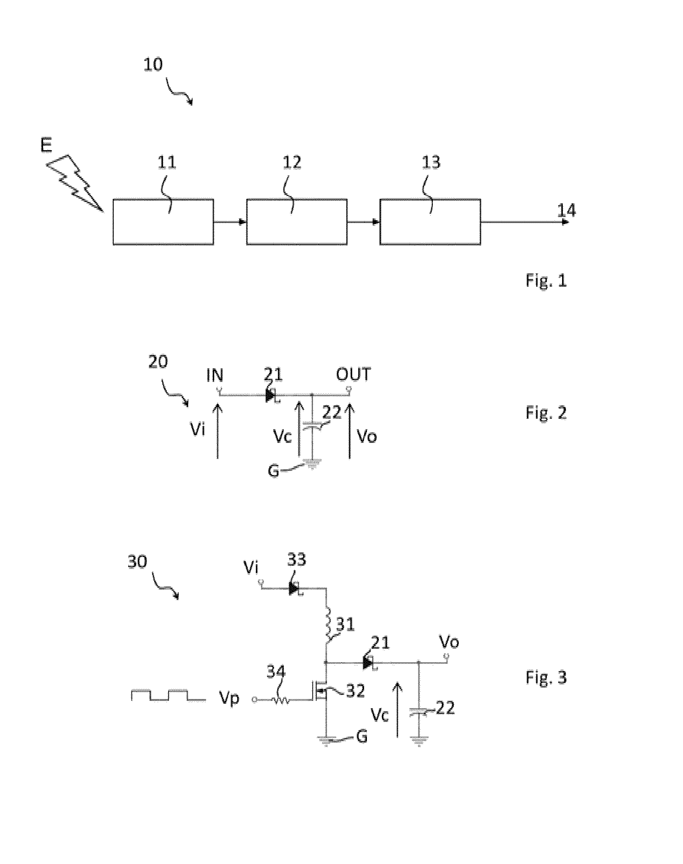

In general, with reference to the block diagram of Figure 1, an energy-harvesting system, designated as a whole by the reference number 10, comprises an energy-harvester apparatus 11, which has the task of transducing into electrical energy an energy E available in the external environment. Said energy E may be available in various forms, for example, mechanical energy, kinetic energy, potential energy, thermal energy. By way of example, the apparatus 11 may be a wind generator.

Across the terminals of the energy-harvester apparatus 11 there will then be present a voltage and a current, which have to be appropriately treated via an electronic conditioning stage 12, i.e., a circuit that carries out transfer of electric charge, in order to be able to provide an impedance matching to maximize energy transfer. The energy extracted from the energy-harvester apparatus 11 is accumulated in an energy-storage module 13, for example, a battery, or via supercap capacitive elements, to be sent to a load 14. The energy can also, alternatively, be used directly by the load 14, by collecting it at output from the conditioning stage 12. The conditioning stage set between the energy-harvester apparatus and the energy-storage module assumes a particularly important role in the case where the energy produced by the energy-harvester apparatus is of a limited amount. The energy-transfer efficiency is, in fact, of critical importance above all in the cases where there is little energy available.

Figure 2 shows a known conditioning stage 20 obtained via a rectifier-diode circuit, which can be considered one of the simplest configurations that can be used as energy-conditioning element. Designated by Vi is an input voltage, which is applied to an input node IN and referenced to a reference voltage represented by a ground node G, and comes from the energy-harvester apparatus, and designated by Vo is an output voltage supplied at an output node OUT by the conditioning stage 20 to the load. In what follows, for simplicity, input voltages and nodes, as likewise output voltages and nodes, are designated by the same references. In general, said voltages are referenced to a ground reference, except where differently specified. The input voltage Vi is applied to the anode of a rectifier diode 21, the cathode of which is connected to the output node OUT. Set in parallel on the output node OUT is a storage capacitor 22 on which there is set up a storage voltage Vc. If the input voltage Vi is a sinusoidal wave, said rectifier circuit lets through on the storage capacitor 22 only the positive half-waves of the input waveform.

One of the main limits of such a configuration is that the system is characterized by an activation threshold, i.e., the system does not enter into operation if the input voltage is lower than a threshold voltage Vγ of the rectifier diode 21. This is particularly penalizing when operating in the context of an energy-harvesting system, with low stimulation voltages at input to the conditioning stage. In addition, the system does not transfer energy in the case of negative half-waves, while to be able to transfer energy from the input of the system to the storage element in the case where the latter has already reached a voltage Vc, it is necessary for the input signal to have an intensity higher than Vγ + Vc; otherwise, there is no energy transfer.

To be able to transfer the negative half-waves, it is known to use a diode-bridge configuration instead of the rectifier diode; however, in this case, the system has an activation voltage equal to 2*Vγ, while to be able to transfer energy from the input of the conditioning stage to the storage element, in the case where the latter has already reached a voltage Vc, it is necessary for the input signal to have an intensity higher than 2*Vγ + Vc; otherwise, there is no energy transfer.

A further improvement of said conditioning stage envisages resorting to the use of a step-up converter.

Figure 3 shows a step-up-converter conditioning stage 30. The input voltage Vi is applied, through an energy-storage series inductor 31, to the anode of the diode 21. A transistor 32, driven, through a series resistor 34 applied at its own gate electrode, by means of a square-wave driving signal Vp, operates as switch: in the closed state, it causes an increase of current in the inductor 31; in the open state, it leaves the only electrical path for the energy accumulated in the inductor 31 through the diode 21, the capacitor 22, and the load 14 shown in Figure 1, which comes to be connected to the output node OUT, thus transferring the energy to the capacitor 22. The resistor 34 is optional in so far as it is a protection resistor.

The introduction of the transistor 32, usually a MOSFET, enables transfer of charge also for input voltages lower than the voltage of the storage element Vc. However, said introduction in itself would render the circuit critical in the case where voltages with negative polarity with respect to the reference are applied at input. Negative input voltages cause a flow of current through the junction of the MOSFET used as switching element. The input is in practice seen as a short circuit. To prevent said flow of current through the junction of the MOSFET, a diode 33 for protection from reversal of polarity, in particular a Schottky diode, is set at input to the system upstream of the inductor 31.

However, also a stage of this sort maintains an activation voltage equal to the threshold voltage Vγ of the anti-reversal diode 33, and the stage does not transfer energy in the case of negative half-waves.

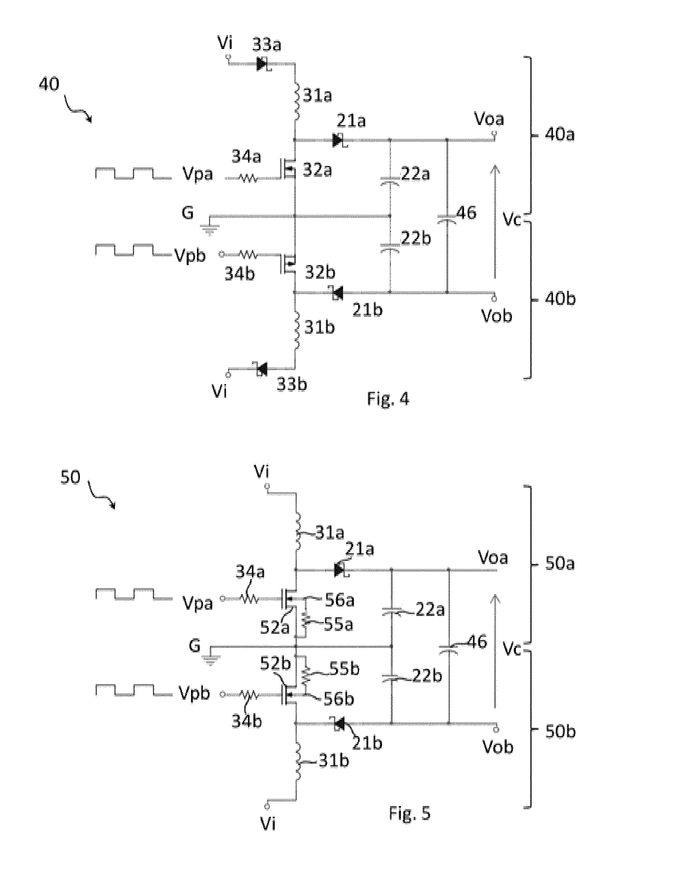

In order to be able to exploit the energy available in the presence of both negative and positive half-waves, it is possible to resort to the conditioning stage 40 using a step-up converter with symmetrical circuit illustrated in Figure 4.

Said circuit corresponds to the circuit represented in Figure 3, but replicated symmetrically on two branches, a top branch 40a for the positive half-waves of the input voltage Vi and a bottom branch 40b for the negative half-waves of the input voltage Vi. In Figure 4, the components of the top branch 40a maintain the references of the corresponding components of the single circuit of Figure 3, but are designated by the suffix "a", whereas the components of the bottom branch 40b are designated by the suffix "b". At output, each branch 40a or 40b comprises a respective storage capacitor 22a or 22b, connected between the respective output node Voa or Vob. The output nodes Voa and Vob are adopted as output terminals of the system. It may be noted how the output is no longer referenced to ground. A further capacitor 46 is then connected between said top and bottom output nodes Voa and Vob, which in variants may even not be present.

The anti-reversal diodes 33a and 33b are then inserted at input to the two branches to obviate the application of voltages of a polarity opposite to the one required by the branch. In the symmetrical configuration, in fact, without the anti-reversal diode, operation of the directly biased branch would be inhibited by the reversely biased branch, which would behave as a short circuit and would hence cause all the current to be transferred to ground.

The transistors 32a and 32b are driven by respective driving voltages Vpa and Vpb.

As a result of the symmetrical circuit, the top output node Voa will tend to assume progressively higher potentials with respect to the reference voltage, in particular the ground node G, whilst the bottom output node Vob will tend to assume progressively lower potentials. The MOSFET 32a of the top branch 40a for the positive half-waves is of an N type (as for the previous configurations), whereas the MOS for the negative branch is of a P type.

However, also a conditioning stage of the above sort maintains a "level of deafness" or of activation equal to the voltage Vγ of the anti-reversal diodes 33a and 33b.

The aim of present invention is to provide a charge-transfer conditioning circuit that will solve the drawbacks of the known art, enabling high-efficiency operation even in the presence of low stimulation voltages at output from the energy-harvester apparatus and irrespective of the polarity with which these voltages are generated by the latter.

According to the present invention, the above aim is achieved thanks to a circuit having the characteristics recalled specifically in the ensuing claims. The invention also regards a corresponding method.

Further characteristics and advantages of the invention will emerge from the ensuing description with reference to the annexed drawings, which are provided purely by way of nonlimiting example, and in which:
- Figures 1, 2, 3, 4 have already been described previously;
- Figure 5 illustrates a circuit diagram of an apparatus according to the invention;
- Figures 6a, 6b and 7a, 7b represent circuit diagrams illustrating operating states of components used by the apparatus according to the invention;
- Figure 8 illustrates a circuit diagram of a variant of the apparatus of Figure 5;
- Figure 9 illustrates a circuit diagram of a second variant of the apparatus of Figure 5;
- Figure 10 illustrates a circuit diagram of a third variant of the apparatus of Figure 5.

In summary, the apparatus according to the invention adopts a voltage-conversion conditioning stage, which envisages adopting a specific configuration of the MOSFETs to get round the limits introduced by the activation thresholds of the system due to the anti-reversal diodes normally used.

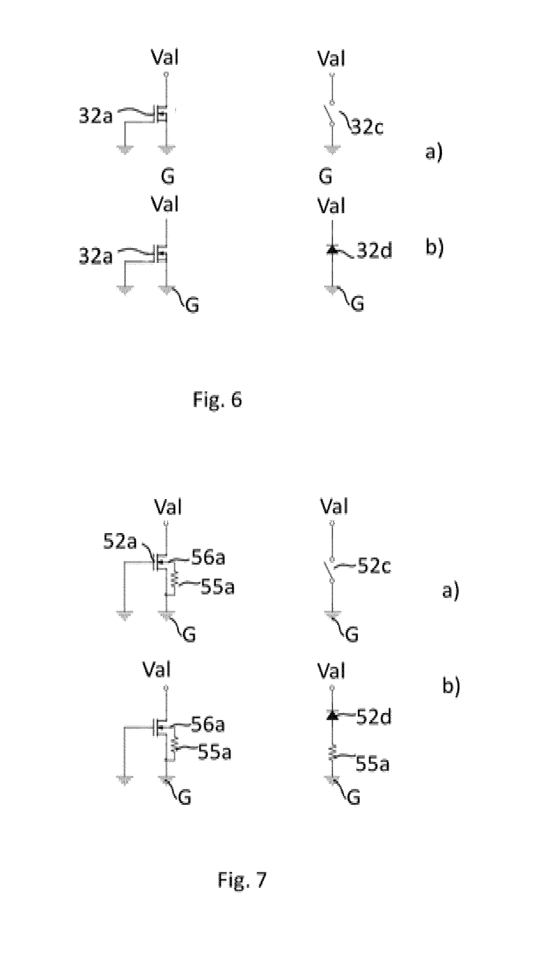

With reference to Figure 6, which shows the states of a generic MOSFET of an N type, or N-MOSFET, 32a as the ones used in Figure 4, an N-MOSFET with a gate-to-source voltage Vgs = 0, i.e., with gate set at ground, behaves as open circuit if it is directly biased, i.e., with a drain-to-source voltage Vds other than zero (in Figure 6a it is in fact indicated as a corresponding open switch 32c), and as closed circuit if it is reversely biased, i.e., with a drain-to-source voltage Vds lower than zero. In this latter case, represented schematically in Figure 6b, it is equivalent to a diode 32d reversely biased between the supply voltage Val and the ground node G. This happens in so far as the biasing substrate of the channel of the N-MOSFET is internally biased via direct connection to the source terminal.

In order to reduce the passage of current in the equivalent diode 32d (in the case of reverse biasing) but to guarantee a proper biasing of the substrate or bulk, according to the invention it is envisaged to introduce a resistive element 55 of a sufficiently high value between the substrate and the source. The value of the resistive element 55 depends upon a considerable amount of factors; it must be sufficiently low as to be able to guarantee biasing of the substrate, but sufficiently high as to limit the current in the case of reverse biasing. By way of example, an effective limitation of the reverse current is obtained with a value of the resistive element 55 that determines the bulk-biasing resistance equal to 1 MΩ for gate-to-source voltages Vgs of 100 mV and maximum drain-to-source voltages Vds of around 500 mV. In general, the resistance will be at least higher than 1 kΩ and lower than 100 MΩ. Figures 7a and 7b exemplify the states of opening and closing of an N-MOSFET 52a that adopts said resistive element 55, for example, a simple resistor. Via said configuration it is possible to render infinitesimal the passage of current in the case of reverse biasing of the system, illustrated in Figure 7b, in so far as set in series to the equivalent diode 52d is the series resistance 55, in any case guaranteeing proper operation of the N-MOSFET, thanks to the bulk-biasing resistance, in the case of direct biasing.

Figure 5 represents the overall circuit diagram of a conditioning stage 50 according to the invention, which is a conditioning stage with conversion of a step-up type and symmetrical architecture, similar to the one shown in Figure 4, but envisages adopting in a first top branch 50a and in a second bottom branch 50b, instead of the MOSFETs 32a and 32b, the transistors 52a and 52b with bulk-biasing resistance 55. In various embodiments, it is possible to adopt open-bulk N-MOSFETs for the branch 50a of the positive half-waves and open-bulk P-MOSFETs for the branch 50b of the negative half-waves. In the circuit illustrated in Figure 6 an N-MOSFET is, however, used also for the negative branch: this does not jeopardize operation of the circuit, but has as a consequence a slight alteration of the performance for the negative branch.

Said transistors 52a, 52b are preferably of a so-called "open bulk" type, i.e., the bulk or substrate is not short-circuited to the source via a metallization as in the transistors 32, but has an electrode accessible for connection of the biasing resistance 55 external to the transistor, in particular a back-gate electrode that is not internally connected. For example, it is possible to use the component SD214DE marketed by Linear Integrated Systems.

The solution of adopting open-bulk transistors exploiting the accessible electrode of the bulk for connection of a biasing element, which is connected also to a potential suitable for enabling biasing of the substrate, can be extended also to circuit architectures other than the step-up converter.

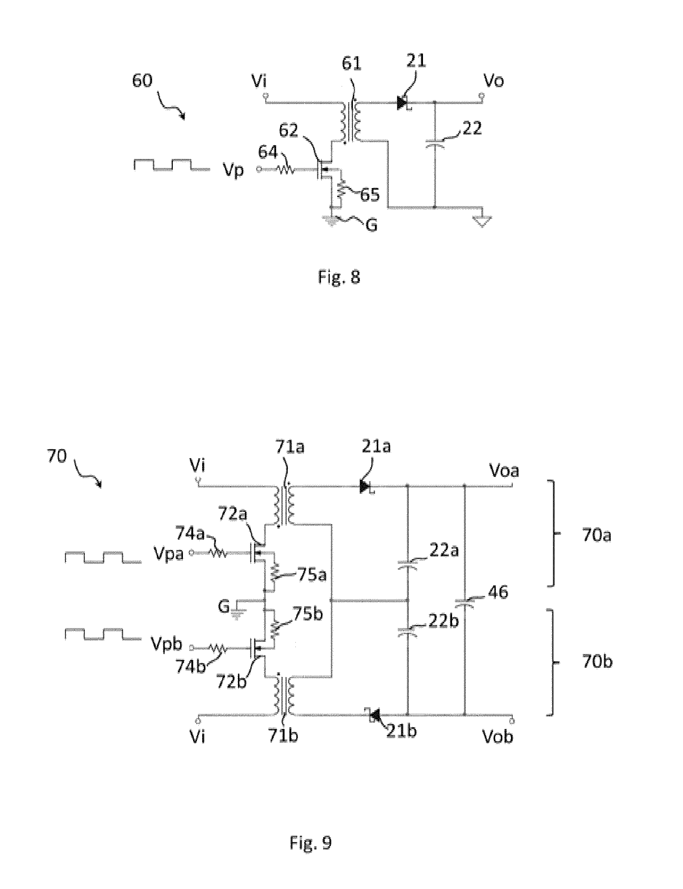

Figure 8 represents, for example, a flyback DC-DC converter 60 with single branch that uses the solution according to the invention. Said converter 60 basically comprises a transformer 61, which receives the input voltage Vi on its primary winding, and a transistor 64 connected between the other end of the primary of the transformer 61 and the ground of the primary. According to the flyback technique, in itself known, the transistor 62 connects and disconnects selectively the transformer 61 to/from the input voltage Vi, under the control of the square-wave driving signal Vp, applied through a series resistor 64 applied to the gate electrode of the transistor 62, accumulating energy during connection and then transferring it to the output, where the load circuit is located, which comprises, in a way similar to the boost architecture, the rectifier diode 21 and the storage capacitor 22.

Also in this flyback architecture the known solutions envisage setting an anti-reversal diode on the input pin, like the diode 33 of Figure 3. In the circuit 60, in a way similar to the circuit 50, instead, it is envisaged to introduce a resistive element 65 between the bulk and the source of the transistor 62, of a value sufficiently high as to limit the current in the case of reverse biasing.

Figure 9 shows, instead, a double flyback converter in symmetrical configuration 70, which replicates on two branches, one for the positive half-waves of the input voltage Vi and one for the negative half-waves, the structure of the flyback converter 60, and hence comprises respective transformers 75a and 75b on the two branches, associated to corresponding transistors 72a and 72b. The load circuit, in a way similar to what is shown in Figure 5, for each branch 70a or 70b comprises a respective storage capacitor 22a or 22b, connected between the respective output node Voa or Vob and a further capacitor 46 connected between said top output node Voa and bottom output node Vob. Also in said symmetrical flyback converter, the known solutions envisage inserting at input to the two branches anti-reversal diodes to obviate the application of voltages with a polarity opposite to the one required by the branch. The converter 70 is, instead, without said diodes, protection of the reversely biased branch of the flyback converter being guaranteed by the use of the open-bulk MOSFETs 75a and 75b, the bulk of which is biased via resistive elements 75a and 75b connected between the respective source electrodes and the bulk.

The bulk or substrate of the open-bulk transistor, in a preferred version is directly connected to the source electrode, through the biasing element or circuit, which is a resistor or a resistive network. However, said substrate can be connected, via the biasing circuit, also to another node of the circuit on which there is set up a potential different from the one present on the source electrode, i.e., suitable for enabling operation of the MOSFET in the linear region or in the saturation region, i.e., enabling normal operation thereof. The biasing circuit provides a limiting resistance in regard to the current that flows from said reference node in the transistor when this operates in the inhibition region.

For example, with reference to the architecture of Figure 5, the biasing element of the transistor of the positive branch can be connected via the resistor to a potential lower than that of the substrate, which is also negative, whereas for the transistor of the negative branch it can be connected to a higher potential. Said potential can be supplied by a purposely provided circuit, for example a microcontroller, and also driven in an active way, by setting dynamically the value of the resistance.

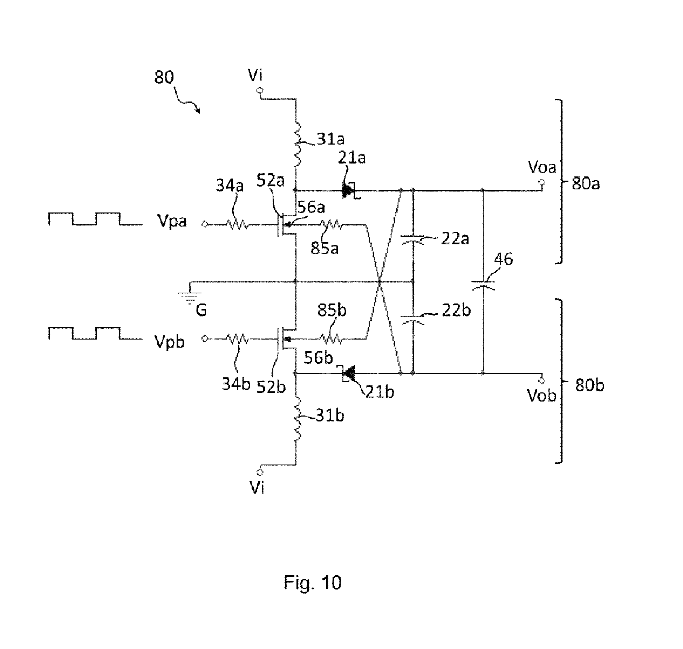

In this regard, according to a possible variant, in the symmetrical architecture it is possible to connect the bulk-biasing circuit of the transistor of the positive branch to the bottom output node, on which negative voltages are set up, and, vice versa, connect the biasing element, or the resistor, of the bulk of the transistor of the negative branch to the top output node, on which positive voltages are set up, as shown in Figure 10, where a step-up converter architecture 80 is illustrated, with a top branch 80a and a bottom branch 80b, where the resistor 85a is connected to the bottom output node Vob on the bottom branch 80b, on which a negative voltage is set up, whilst the resistor 85b is connected to the top output node Voa on the top branch 80a, on which a positive voltage is set up. Of course, in various embodiments, said resistors may not be connected directly to the output nodes, but via dividers or other circuit elements. The components similar to those of Figure 5 are designated by the same references.

With the proposed circuit configuration the limits characteristic of the various solutions previously illustrated are hence overcome.

In fact, via the adoption of open-bulk transistors with a biasing circuit connected to the bulk that limits the current, it is advantageously possible to remove the anti-reversal diodes between the input nodes and the inductors, eliminating the corresponding voltage drop due to the voltage threshold. Consequently, the conditioning stage no longer has a low level of attention, or deafness, due to the threshold voltage of the diodes. This is particularly advantageous in the cases of symmetrical architectures, where the circuit starts to operate even at very low values of input voltage, rendering the circuit according to the invention extremely suitable for application to harvesting of energy even where this is available in low amounts that determine low input voltage. This is obtained via the adoption of a converter architecture combined to the use of field-effect-transistor switches comprising field-effect transistors, in particular MOSFETs, specifically N-MOSFETs for the positive branch and P-MOSFETs for the negative branch, but also indifferently only P-MOSFETs or N-MOSFETs, at the expense of a reduction of performance of the branch involved, as mentioned previously, in which a biasing element, for example a resistor, preferably sets in connection the source electrode with the bulk, limiting in a drastic way the current that can flow in the junction of the MOSFET when there are negative voltages at input. The biasing element can also be connected between the bulk of the MOSFET and another reference voltage of the circuit, and hence not necessarily to ground G, as has been shown.

Of course, without prejudice to the principle of the invention, the details of construction and the embodiments may vary widely with respect to what is described and illustrated herein purely by way of example, without thereby departing from the scope of the present invention. Even though in the examples of embodiment as diodes Schottky diodes have been mostly indicated, even normal junction diodes can be used; likewise, the storage capacitors, represented in the embodiments as electrolytic capacitors, may also be obtained via other types of capacitors.

## Claims

1. A conditioning circuit for the transfer of electric charge, which comprises a converter module (40, 50, 60, 70) comprising an energy-storage element (31a, 31b; 61; 71a, 71b) applied to which is an input voltage (Vi) and a respective field-effect-transistor switch (32a, 32b; 52a, 52b; 62; 72a, 72b) controlled by a respective driving signal (Vpa, Vpb) for selectively enabling transfer of charge from the energy-storage element (31a, 31b; 61; 71a, 71b) to an energy-storage circuit (13, 22a, 22b, 46),
said circuit being **characterized in that**
said respective field-effect-transistor switch (52a, 52b; 62; 72a, 72b) comprises a corresponding field-effect transistor (52a, 52b) and a biasing circuit (55a, 55b; 65; 75a, 75b; 85a, 85b) for biasing a substrate (56a, 56b) of said transistor (32a, 32b; 52a, 52b; 62; 72a, 72b), said biasing circuit being connected between said substrate (56a, 56b) and a reference node represented by a source electrode of said transistor (52a, 52b) or another node at a potential suitable for enabling operation of said transistor (52a, 52b; 62; 72a, 72b) in the linear region or in the region of saturation, said biasing circuit (55a, 55b; 65; 75a, 75b; 85a, 85b) being configured for providing a limiting resistance in regard to the current that flows from said reference node in the transistor (52a, 52b; 62; 72a, 72b) when it operates in the inhibition region.

2. The circuit according to claim 1, **characterized in that** said biasing circuit (55a, 55b; 65; 75a, 75b) comprises a resistor or a resistive circuit configured as being connected between said substrate (56a; 56b) and a source electrode of said transistor (52a, 52b; 62; 72a, 72b).

3. The circuit according to claim 1 or claim 2, **characterized in that** said field-effect transistor (52a, 52b; 62; 72a, 72b) is a MOSFET of an open-bulk type, the bulk or substrate of which has an electrode accessible for connection of said biasing circuit (55a, 55b; 65; 75a, 75b; 85a, 85b).

4. The circuit according to claim 1 or claim 2 or claim 3, **characterized in that** said converter (50; 80) is a converter module of a step-up type.

5. The circuit according to any one of the preceding claims, **characterized in that** said converter (50; 80) is a converter module of a symmetrical step-up type, comprising a first step-up conversion branch (50a; 80a) and a second step-up conversion branch (50b; 80b), each one between said first branch (50a; 80a) and said second branch (50b; 80b) comprising as energy-storage element a respective energy-storage inductor (31a, 31b) and a respective field-effect-transistor switch (52a, 52b) controlled by a respective driving signal (Vpa, Vpb) for setting in electrical connection said inductor (31a, 31b) alternatively with a reference voltage, in particular a ground node, or with a storage circuit (13, 22a, 22b, 46), said respective field-effect-transistor switch (52a, 52b) comprising a corresponding field-effect transistor (52a, 52b) and a resistor (55a; 55b) connected between a source electrode of said field-effect transistor (52a, 52b) and a substrate (56a, 56b) thereof.

6. The circuit according to claim 5, **characterized in that** the biasing circuit (85a) of the first branch (80a) is configured as being connected between the substrate (56a) of the transistor (52a) of the first branch (80a) and the output voltage (Vob) of the second branch (80b), and the biasing circuit (85b) of the second branch is configured as being connected between the substrate (56b) of the transistor (52b) of the second branch (80b) and the output voltage (Voa) of the first branch (80a).

7. The circuit according to claim 1 or claim 2 or claim 3, **characterized in that** said converter (60; 70) is a converter module of a flyback type.

8. The circuit according to claim 7, **characterized in that** said flyback converter (70) is a symmetrical flyback converter module, comprising a first flyback conversion branch (70a) and a second flyback conversion branch (70b), each one between said first branch (70a) and said second branch (70b) comprising as energy-storage element (71a, 71b) a respective energy-storage transformer and a respective field-effect-transistor switch (72a, 72b) controlled by a respective driving signal (Vpa, Vpb) for connecting selectively the respective transformer (71a, 71b) to the input voltage (Vi).

9. The circuit according to one or more of the preceding claims, **characterized in that** the input voltage (Vi) is applied directly to the energy-storage element (31a, 31b; 61; 71a, 71b) or the input voltage (Vi) is applied to the energy-storage element (31a, 31b; 61; 71a, 71b) without interposition of anti-reversal components or circuits, in particular of the diode type.

10. The circuit according to one or more of the preceding claims, **characterized in that** said input voltage (Vi) to be converted is generated by an energy-harvester apparatus (11).

11. The circuit according to one or more of the preceding claims 5 to 10, **characterized in that** said storage circuit (22a, 22b, 46) comprises, respectively, for the first branch (50a; 70a; 80a) and the second branch (50b; 70b; 80b) a diode (21a, 21b), respectively connected for being directly biased for the positive or negative half-waves of the input voltage (Vi) and for causing flow of current towards at least one storage capacitor (22a, 22b) connected between a respective output node (Voa, Vob) and the reference voltage, in particular a ground node (G).

12. The circuit according to one or more of the preceding claims 5 to 11, **characterized in that** said first branch (50a; 70a; 80a) is a branch for the positive half-waves of the input voltage (Vi) and the respective field-effect transistor (52a; 72a) is an open-bulk N-MOSFET, whilst the second branch (50a; 70a; 80a) is a branch for the negative half-waves of the input voltage (Vi) and the respective field-effect transistor (52b; 72b) is an open-bulk P-MOSFET.

13. The circuit according to one or more of the preceding claims 5 to 11, **characterized in that** said first branch (50a; 70a; 80a) and said second branch (50b; 70b; 80b) comprise an N-MOSFET.
